# EUROPEAN PATENT APPLICATION

(11) **EP 1 887 630 A2**
(43) Date of publication of application: **13.02.2008**
(21) Application number: 07015152.7
(22) Date of filing: 02.08.2007
(51) Int. Cl.: H01L 27/32

(54) **Thin film transistor array panel and method of manufacturing the same**

(30) Priority: 11.08.2006 KR 20060076021; 18.08.2006 KR 20060077988
(71) Applicant: Samsung Electronics Co., Ltd., Yeongtong-gu Suwon-city, Gyeonggi-do 442-742 (KR)
(72) Inventor: Shin, Jung-Han, Giheung-gu Yongin-si Gyeonggi-do (KR); Song, Keun-Kyu, Suji-gu Yongin-si Gyeonggi-do (KR); Choi, Tae-Young, Seongbuk-gu Seoul (KR); Kim, Young-Min, Suji-gu Yongin-si Gyeonggi-do (KR); Oh, Joon-Hak, Suji-gu Yongin-si Gyeonggi-do (KR); Cho, Seung-Hwan, Dongtan-myeon Hwaseong-si Gyeonggi-do (KR)
(74) Representative: Weitzel, Wolfgang

(57) **Abstract**

Disclosed is a thin film transistor array panel including a substrate, a data line (171) formed on the substrate, a gate line (121) that intersects the data line and includes a gate electrode (124), a source electrode (133) connected to the data line (171), and a drain electrode (135) facing the source electrode (133). An organic semiconductor (154) contacts the source electrode (133) and the drain electrode (135) via an insulating layer (140) having an opening (146) that defines the location of the organic semiconductor (154). The insulating layer (140) includes an acrylic photosensitive resin having a fluorine-containing compound. A method of manufacturing the above described thin film transistor array panel is disclosed.

## Description

### BACKGROUND OF THE INVENTION

### (a) Field of the Invention

This invention relates to a thin film transistor array panel and a method of manufacturing the same.

### (b) Description of the Related Art

Generally, a flat panel display such as a liquid crystal display (LCD), an organic light emitting device, and an electrophoretic display includes a pair of electric field generating electrodes and an electro-optical active layer interposed therebetween. The LCD includes a liquid crystal layer as an electro-optical active layer, and the organic light emitting device includes an organic light emitting layer as an electro-optical active layer.

One of the pair of the electric field generating electrodes is commonly connected to a switching element to receive an electrical signal, and the electro-optical active layer displays image by transforming the electrical signal into an optical signal.

A thin film transistor (TFT), that is three-terminal element is used as a switching element in the flat panel display. The flat panel display includes a gate line transmitting a scanning signal and a data line transmitting a data signal that is applied to a pixel electrode so as to control the TFT.

An organic thin film transistor (OTFT) has been actively studied in recent years. The OTFT includes an organic semiconductor instead of an inorganic semiconductor such as Si.

Since the OTFT may have the form of a fiber or film type depending on the flexible properties of an organic substance, it has been identified as a core component of a flexible display device.

In addition, since the OTFT may be manufactured by a solution process such as an ink-jet printing process, it may be easily applied to the flat panel display of a large area by using only deposition process.

In the ink-jet printing process, an organic solution is injected into a prescribed region defined by a partition by moving an ink jet head provided with a nozzle. An organic thin film such as an organic semiconductor and an organic insulator may be easily formed by the ink-jet printing process.

In this case, the partition has a surface property different to that of the organic solution, which prevents the solution from flowing over the partition, thus forming the organic thin film at only the desired position. For example, when the organic solution has a hydrophilic property, the surface of the partition may be treated so as to have a hydrophobic property by surface treatment. Alternatively, when the organic solution has a hydrophobic property, the surface of the partition may be treated so as to have a hydrophilic property by surface treatment.

An additional process using plasma is required for the above-described surface treatment.

However, in the surface treatment using plasma, effects of the surface treatment are not maintained for a long time, and both the surface of the partition and a position at which the organic thin film will be formed are treated with plasma. Therefore, the thickness of the organic solution may be uneven.

### SUMMARY OF THE INVENTION

The present invention has been made in an effort to provide a thin film transistor array panel and a method of manufacturing the same having advantages of modifying a surface of a partition without an additional plasma process.

An exemplary embodiment of the present invention provides a thin film transistor array panel including a substrate; a data line formed on the substrate; a gate line that intersects the data line and includes a gate electrode; a source electrode connected to the data line; a drain electrode facing the source electrode; an insulating layer having an opening and formed by an acrylic photosensitive resin having a fluorine-containing compound; and an organic semiconductor formed in the opening and contacting with the source electrode and the drain electrode;.

The photosensitive resin may have a thermal cross-linkage ability.

The fluorine-containing compound may include at least one of a fluoro-surfactant, fluoro-nanoparticles, or fluoropolymer nanobeads.

The fluorine-containing compound may be contained at about 1 to 40 wt% within the insulating layer.

The insulating layer may have a thickness of from about 10 Å to 7000 Å.

The top surface of the insulating layer may has stronger hydrophobic property than a portion contacting a bottom surface of the organic semiconductor. The thin film transistor array panel may further include a gate insulator located between the organic semiconductor and the gate electrode, and at least one of the semiconductor and the gate insulator may include a soluble material.

The data line and the source electrode may include different materials, and the source electrode and the drain electrode may include indium tin oxide (ITO) or indium zinc oxide (IZO).

The thin film transistor array panel may further include a light blocking layer located below the organic semiconductor.

Another embodiment of the invention provides a manufacturing method of a thin film transistor array panel including forming a data line on a substrate; forming a gate line that intersects the data line; forming a source electrode connected to the data line and a drain electrode facing the source electrode; forming an insulating layer having an opening; and forming an organic semiconductor contacting with the source electrode and the drain electrode in the opening,. In this configuration, the forming of the insulating layer may include forming an acrylic photosensitive resin layer having a fluorine-containing compound and forming the opening by patterning the photosensitive resin layer.

The forming of the photosensitive resin layer may include applying a photosensitive resin, exposing and developing the photosensitive resin, and thermally crosslinking the photosensitive resin at about 130°C to 250°C.

The forming of the organic semiconductors may be performed by an ink-jet printing process.

Still another embodiment of the invention provides a manufacturing method of a thin film transistor array panel including forming a data line on a substrate; forming a first interlayer insulating layer on the data line; forming a source electrode connected to the data line and drain electrode facing the source electrode on the first interlayer insulating layer; forming an acrylic photosensitive resin layer having a fluorine-containing compound on the source electrode and the drain electrode; forming a second interlayer insulating layer having an opening by patterning the photosensitive resin layer; forming an organic semiconductor in the opening; forming a gate insulator on the organic semiconductor; and forming a gate line on the gate insulator and the second interlayer insulating layer.

The forming of the photosensitive resin layer may include applying a photosensitive resin, exposing and developing the photosensitive resin, and thermally crosslinking the photosensitive resin at a temperature of from about 130°C to 250°C.

The forming of the organic semiconductors and the forming of the gate insulator are performed by an ink-jet printing process.

Yet another embodiment of the invention provides a manufacturing method of a thin film transistor array panel including forming a gate line on a substrate; forming a data line that intersects the gate line; forming a source electrode connecting with the data line and a drain electrode facing the source electrode; forming an insulating layer having an opening; and forming an organic semiconductor contacting with the source electrode and the drain electrode in the opening,. In this configuration, the forming of the insulating layer may include applying a photosensitive organic layer on a printing plate having at least one of a concave portion and a convex portion, transferring the photosensitive organic layer onto the substrate, and removing a solvent from the photosensitive organic layer that is transferred onto the substrate.

The method of manufacturing the thin film transistor, array panel may further include performing a surface-treatment of the insulating layer.

The surface-treatment of the insulating layer may include supplying a fluorine-containing gas onto the insulating layer.

Yet another embodiment of the invention provides a method of manufacturing a thin film transistor array panel, the method including forming a data line on a substrate; forming a gate line that intersects the data line; forming a source electrode connected to the data line and a drain electrode facing the source electrode; forming an insulating layer having an opening; and forming an organic semiconductor contacting with the source electrode and the drain electrode in the opening, wherein the forming of the insulating layer comprises applying a photosensitive organic layer on an printing plate having at least one of a concave portion and a convex portion, transferring the photosensitive organic layer onto the substrate, and removing a solvent from the photosensitive organic layer that is transferred onto the substrate.

### BRIEF DESCRIPTION OF THE DRAWINGS

FIG. 1 is a layout view of a thin film transistor array panel according to a first embodiment of the present invention;
FIG. 2 is a cross-sectional view taken along a line II-II of FIG.1;
FIG. 3, FIG. 5, FIG. 7, FIG. 9, FIG. 11, and FIG. 13 are layout views sequentially showing a method of manufacturing the thin film transistor array panel of FIG. 1 and FIG. 2 according to the first embodiment of the present invention;
FIG. 4 is a cross-sectional view taken along a line IV-IV of FIG. 3;
FIG. 6 is a cross-sectional view taken along a line VI-VI of FIG. 5;
FIG. 8 is a cross-sectional view taken along a line VIII-VIII of FIG. 7;
FIG. 10 is a cross-sectional view taken along a line X-X of FIG. 9;
FIG. 12 is a cross-sectional view taken along a line XII-XII of FIG.11;
FIG. 14 is a cross-sectional view taken along a line XIV-XIV of FIG.13;
FIG. 15 is an enlarged cross-sectional view showing a thin film transistor array panel according to a second embodiment of the present invention;
FIG. 16 to FIG. 18 are cross-sectional views sequentially showing a method of manufacturing the thin film transistor array panel according to the second embodiment of the present invention;
FIG. 19 and FIG. 20 are plots showing current characteristics of the thin film transistor array panel of FIG. 15.

### DETAILED DESCRIPTION OF THE EMBODIMENTS

The present invention is described more fully hereinafter with reference to the accompanying drawings, in which exemplary embodiments of the invention are shown. As those skilled in the art would realize, the described embodiments may be modified in various different ways, all without departing from the spirit or scope of the present invention.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

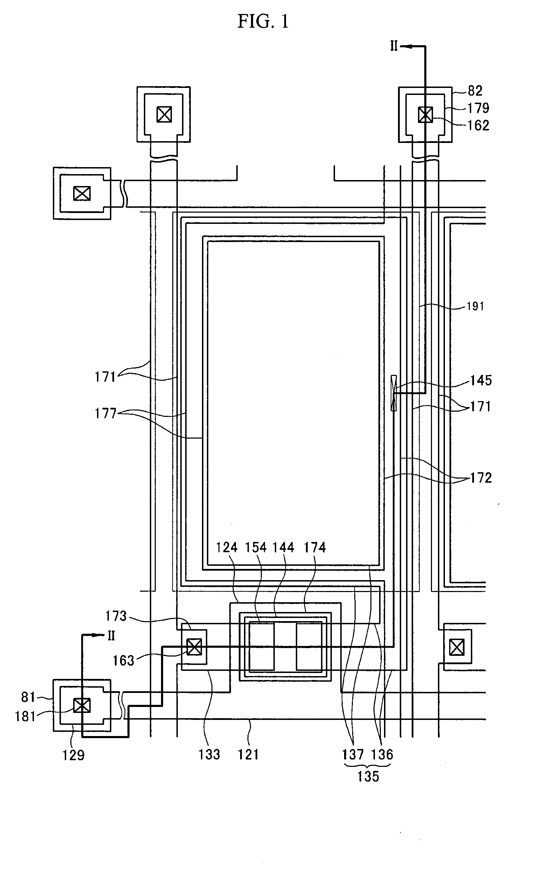

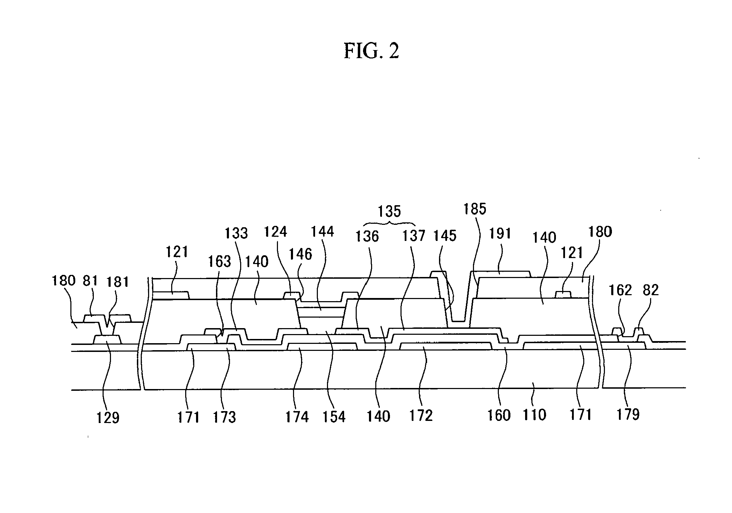

First, a thin film transistor array panel according to one embodiment of the present invention will be described more fully with reference to FIG.1 and FIG. 2.

FIG. 1 is a layout view of the thin film transistor array panel according to one embodiment of the present invention, and FIG. 2 is a cross-sectional view taken along a line II-II of FIG. 1.

A plurality of data lines 171, a plurality of storage electrode lines 172, and a light blocking layer 174 are formed on an insulating substrate 110 made of, for example, transparent glass, silicone, or plastic.

The data lines 171 transmit data signals and extend substantially in a longitudinal direction. Each of the data lines 171 includes a plurality of projections 173 that project sideward and an end portion 179 having a large area for connection with another layer or an external driving circuit. A data driving circuit (not shown) for generating the data signals may be mounted on a flexible printed circuit layer (not shown) attached to the substrate 110, mounted directly on the substrate 110, or integrated onto the substrate 110. When the data driver circuit is integrated onto the substrate 110, the data lines 171 may be extended to be directly connected to the data driver circuit.

The storage electrode lines 172 receive a prescribed voltage, and extend substantially parallel to the data lines 171. Each of the storage electrode lines 172 is located between two data lines 171 so as to be adjacent to the right data line 171. The storage electrode lines 172 include a rounded storage electrode 177 that is divided toward both sides. However, the shape and arrangement of the storage electrode lines 172 may be variously changed.

The light blocking layer 174 is separated from the data lines 171 and the storage electrode lines 172.

The data lines 171, the storage electrode lines 172, and the light blocking layer 174 may be made of, for example, an Al-containing metal such as Al or an A1 alloy, a Ag-containing metal such as Ag or a Ag alloy, a Cu-containing metal such as Cu or a Cu alloy, a Mo-containing metal such as Mo or a Mo alloy, Cr, Ta, and Ti. However, these may have a multi-layered structure including two conductive layers (not shown) having different physical characteristics. However, the data lines 171, the storage electrode lines 172 and the light blocking layer 174 may be made of various metals or conductors besides the above-described materials.

The lateral sides of the data lines 171, the storage electrode lines 172, and the light blocking layer 174 are preferably inclined at an angle between about 30 and about 80 degrees relative to the surface of the substrate 110.

A lower interlayer insulating layer 160 is formed on the data lines 171, the storage electrode lines 172, and the light shielding layer 174. The lower interlayer insulating layer 160 may be made of an inorganic insulating material such as silicon nitride (SiNx) or silicon oxide (SiO₂), and the thickness thereof may be about 2000 to 5000Å.

The lower interlayer insulating layer 160 has a plurality of contact holes 163 and 162 respectively exposing the projections 173 and the end portions of the data line 179.

A plurality of source electrodes 133, a plurality of drain electrodes 135, and a plurality of contact assistants 82 are formed on the lower interlayer insulating layer 160.

Each source electrode 133 may have an island shape to be connected, to a data line 171 through a contact hole 163.

The drain electrodes 135 include a portion 136 (hereinafter, referred to as an "electrode portion") facing the source electrodes 133 on the light blocking layer 174, and a portion 137 (hereinafter, referred to as a "capacitor portion") overlapping at least a part of the storage electrode lines 172. Each electrode portion 136 faces a source electrode 133 to form a part of a thin film transistor (TFT), and a capacitor portion 137 overlaps a storage electrode line 172 and forms a storage capacitor to enhance voltage storage ability.

Each contact assistant 82 is connected to an end portion 179 of a data line 171 through a contact hole 162, complements adhesive properties between the end portion 179 of the data line 171 and the external device, and protects the above elements.

Since the source electrode 133 and the drain electrode 135 directly contact to the organic semiconductor, these are preferably made of conductive materials having a work function substantially similar to the energy level of the organic semiconductor. Thus, it may be possible to easily inject and transfer carriers by lowering the Schottky barrier between the organic semiconductor and the electrode. An example of these materials may include a conductive oxide such as indium tin oxide (ITO) or indium zinc oxide (IZO). The thickness thereof may be about 300Å to 1000Å.

An upper interlayer insulating layer 140 is formed over the substrate including the source electrode 133, the drain electrode 135, and the lower interlayer insulating layer 160.

The upper interlayer insulating layer 140 has a plurality of openings 146 and a plurality of contact holes 145. Each opening 146 exposes a source electrode 133, a drain electrode 135, and the lower interlayer insulating layer 160 located therebetween, and each contact hole 145 exposes a drain electrode 135.

The upper interlayer insulating layer 140 may be made of a resin formed by using an acrylic photosensitive-organic material that includes a fluorine-containing compound and has a thermal cross-linkage ability. The fluorine-containing compound may be, for example, fluoro-surfactant, fluoro-nanoparticles, or fluoropolymer nanobeads. Examples of these may be Zonyl™ (manufactured by Dupont Co.), Novec™ (manufactured by 3M Co.), Fluowet™ (manufactured by Clariant Co.), Lodyne™ (manufactured by Ciba Specialty Chemicals Co.), or Megaface™ (manufactured by DAINIPPON INK AND CHEMICALS CO.).

The fluorine-containing compound is preferably contained in the amount of about 1 to 40 wt% based on the total content of the photosensitive organic substance. If the fluorine-containing compound is contained in the amount of less than about 1 wt%, surface properties are poor. Meanwhile, if the fluorine-containing compound is contained in the amount exceeding about 40 wt%, since the surface tension of the upper interlayer insulating layer 140 becomes too small, layers may be non-uniformly laminated on the upper interlayer insulating layer 140.

As described above, by forming the upper interlayer insulating layer 140 of the photosensitive organic material including the fluorine-containing compound, the surface of the upper interlayer insulating layer 140 may have a hydrophobic property without performing a separate surface-treating process. Meanwhile, since the openings 146 and the contact holes 145 in which the upper interlayer insulating layer 140 is removed do not include the fluorine-containing compound, these may have a relatively hydrophilic property.

A plurality of organic semiconductors 154 are formed in the openings 146 of the upper interlayer insulating layer 140. The organic semiconductors 154 are surrounded by the upper interlayer insulating layer 140, and the upper interlayer insulating layer 140 surrounding the organic semiconductors 154 is a partition defining the regions of the organic semiconductors 154.

Each organic semiconductor 154 comes in contact with a source electrode 133 and a drain electrode 135. Since the height of the organic semiconductor 154 is lower than that of the upper interlayer insulating layer 140, the organic semiconductor 154 is confined by the upper interlayer insulating layer 140. As described above, since the organic semiconductors 154 are fully confined in the upper interlayer insulating layer 140, both sides thereof are not exposed. Accordingly, it is possible to prevent chemical solution or the like from permeating into both sides of the organic semiconductor 154 in following processes.

The organic semiconductors 154 may have a different surface property from the upper interlayer insulating layer 140. For example, when the surface of the upper interlayer insulating layer 140 has a hydrophobic property, as described above, the organic semiconductors 154 are formed of materials having relatively hydrophilic properties. In this case, since the organic semiconductor 154 does not flow over the upper interlayer insulating layer 140 and gathers only in the openings 146 having the same surface properties, the organic semiconductor 154 may be formed at only the desired region.

The organic semiconductor 154 is formed above light blocking layer 174. The light blocking, layer 174 blocks a direct inflow of light supplied from a backlight into the organic semiconductor 154, thus preventing a photoleakage current from being dramatically increased in the organic semiconductor 154.

The organic semiconductor 154 may include a high molecular weight compound or a low molecular weight compound that is soluble in an aqueous solution or organic solvent.

The organic semiconductor 154 may include at least one of pentacene and precursors thereof, tetrabenzoporphyrin and derivatives thereof, polyphenylenevinylene and derivatives thereof, polyfluorene and derivatives thereof, polythienylenevinylene and derivatives thereof, poly 3-hexylthiophene, polythiophene and derivatives thereof, polythienothiophene and derivatives thereof, polyarylamine and derivatives thereof, phthalocyanine and derivatives thereof, metallized phthalocyanine or halogenated derivatives thereof, perylenetetracarboxylic dianhydride (PTCDA), naphthalenetetracarboxylic dianhydride (NTCDA) or imide derivatives of these, and perylene or coronene and derivatives including substituents thereof.

The thickness of the organic semiconductor 154 may be about 300Å to 3000Å.

A gate insulator 144 is formed on the organic semiconductor 154. The gate insulator 144 is formed in the opening 146 of the upper interlayer insulating layer 140, and the sum of the thickness of the organic semiconductor 154 and the gate insulator. 144 is thinner than that of the upper interlayer insulating layer 140.

The gate insulator 144 may be made of, for example, polyacryl and derivatives thereof, polystyrene and derivatives thereof, benzocyclobutane (BCB), polyimide and derivatives thereof, polyvinyl alcohol and derivatives thereof, parylene and derivatives thereof, perfluorocyclobutane and derivatives thereof, and perfluorovinylether and derivatives thereof.

A plurality of gate lines 121 are formed on the gate insulator 144 and the upper interlayer insulating layer 140.

The gate lines 121 transmit a gate signals and extend substantially in a transverse direction to intersect the data lines 171 and the storage electrode lines 172. Each of the gate lines 121 includes a plurality of gate electrodes 124 projecting upward, and an end portion 129 having a large area for connection with another layer or an external driving circuit. A gate driving circuit (not shown) for generating the gate signals may be mounted on a flexible printed circuit layer (not shown) attached to the substrate 110, mounted directly on the substrate 110, or integrated onto the substrate 110. When the gate driver circuit is integrated onto the substrate 110, the gate lines 171 may be extended to be directly connected to the gate driver circuit.

Each gate electrode 124 is overlapped with an organic semiconductor 154 by interposing a gate insulator 144 therebetween, and is formed to have the size larger than that of the opening 146 such that it fully covers the organic semiconductor 154 and the gate insulator 144.

The gate lines 121 may be made of the same materials as the data lines 171 and the storage electrode lines 172.

The lateral sides of the gate lines 121 are also preferably inclined at an angle between about 30 and about 80 degrees relative to the surface of the substrate 110.

A passivation 180 layer is formed on the gate line 121. The passivation layer 180 is also formed on the end portions 129 of the gate lines 121. Therefore, the passivation layer 180 may prevent a short circuit between the end portions 129 of the gate lines 121 and the end portions 129 of adjacent gate lines.

The passivation layer 180 has contact holes 185 and 181.

The contact holes 185 are located on the contact holes 145 formed on the upper interlayer insulating layer 140 to expose the drain electrodes 145, and the contact holes 181 expose the end portions 129 of the gate lines 121.

The passivation layer 180 may be formed on a part or the entire surface of the substrate to protect the organic TFT and the gate lines 121, and may be omitted in some cases.

Pixel electrodes 191 and contact assistants 81 are formed on the passivation layer 180.

Each pixel electrode 191 is connected to a drain electrode 135 through the contact holes 185 and 145.

The pixel electrode 191 may increase the aperture ratio by overlapping the gate lines 121 and/ or the data lines 171.

The pixel electrodes 191 supplied with the data voltage from the TFT generates electric fields in cooperation with a common electrode (not shown) of another array panel (not shown) supplied with a common voltage, thereby determining the direction of liquid crystal molecules in a liquid crystal layer (not shown) disposed between the electrodes. Each pixel electrode 191 and the common electrode (not shown) form a capacitor (hereinafter, referred to as "liquid crystal capacitor") that stores the applied voltage even after the TFT is turned off.

The contact assistants 81 are connected to the end portions 129 of the gate lines 121 through the contact holes 181, and they complement the adhesive properties between the end portions 129 of the gate lines 121 and the external device and protect the above elements.

One TFT is provided with one gate electrode 124, one source electrode 133, and one drain electrode 135 together with the organic semiconductor 154, and the channel of the TFT is formed in the organic semiconductor 154 disposed between the source electrode 133 and the drain electrode 135.

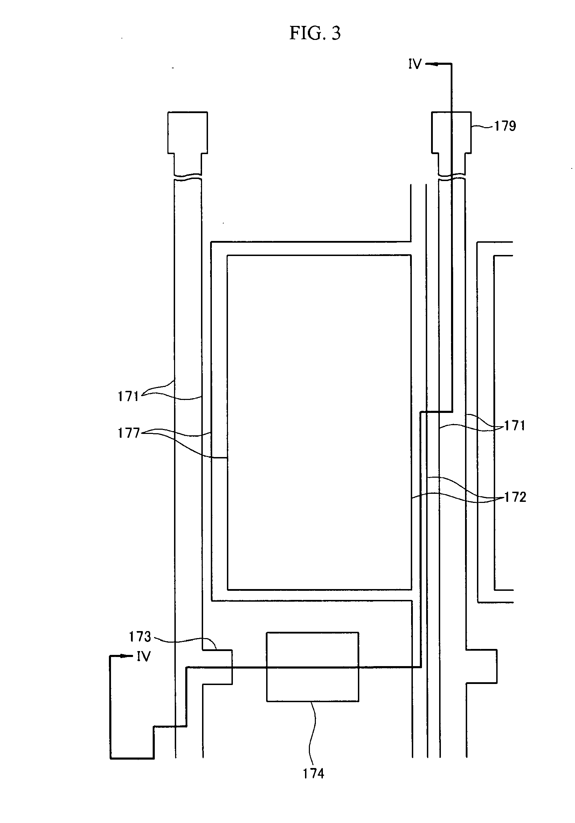

A method of manufacturing the TFT array panel shown in FIG. 1 and FIG. 2 is described below in detail with reference to FIG. 3 to FIG. 14.

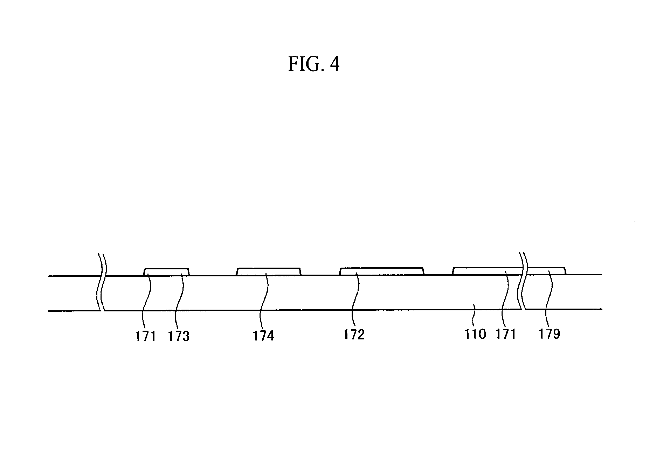

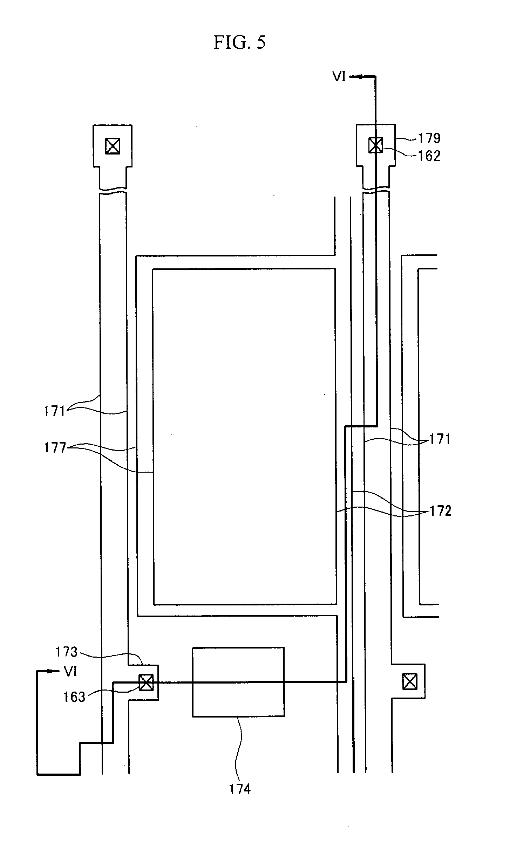

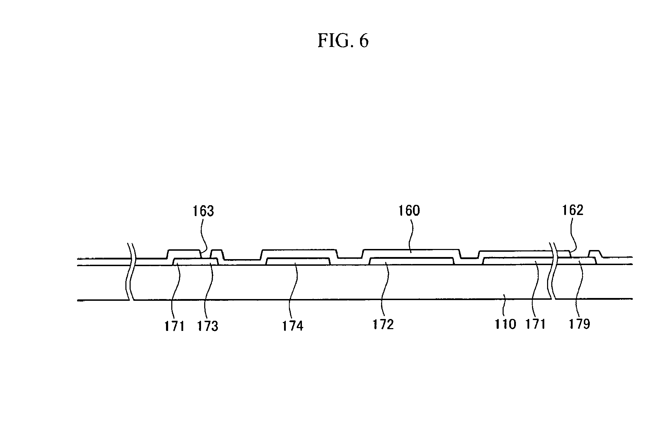

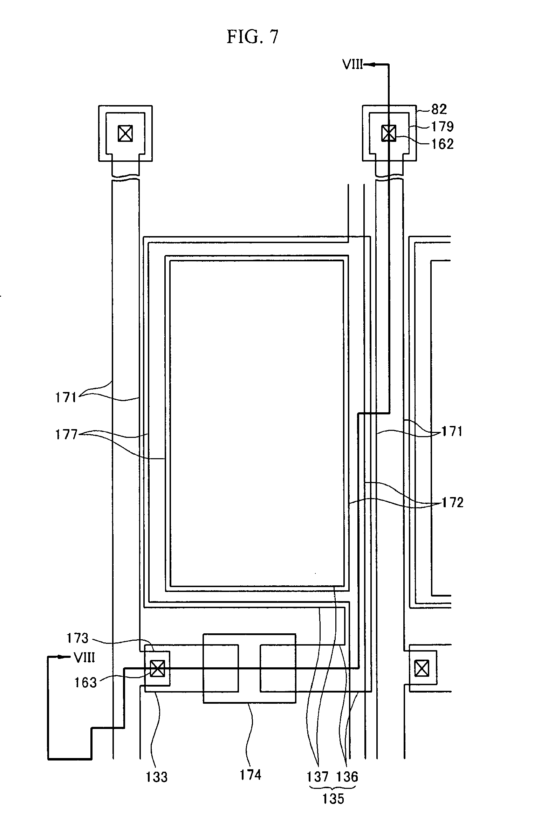

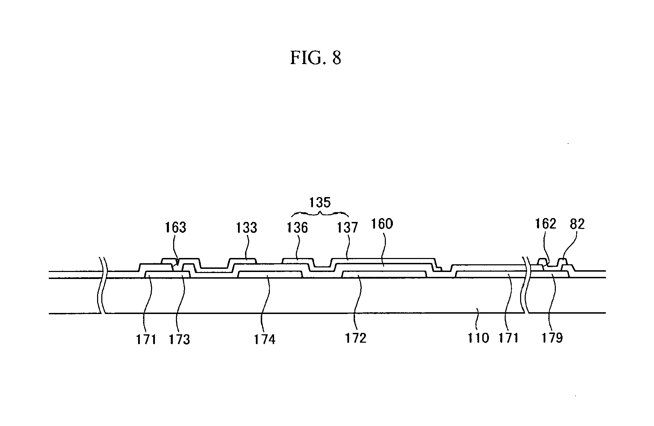

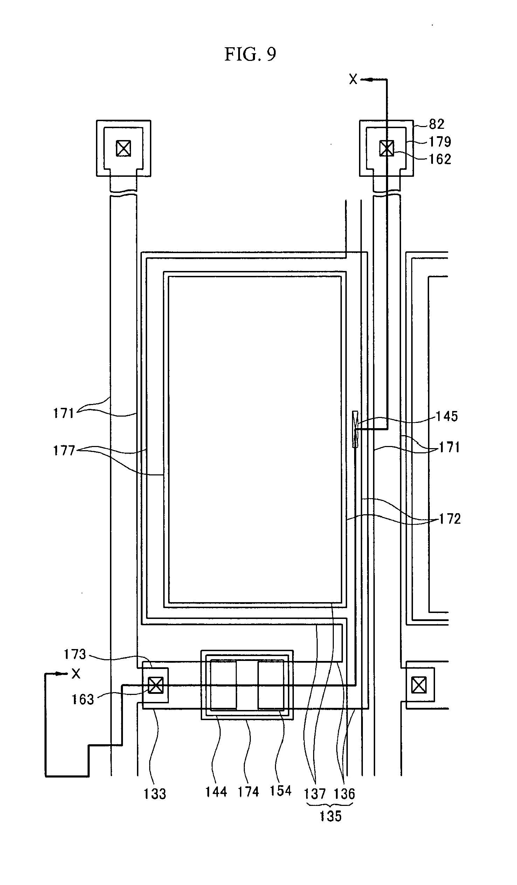

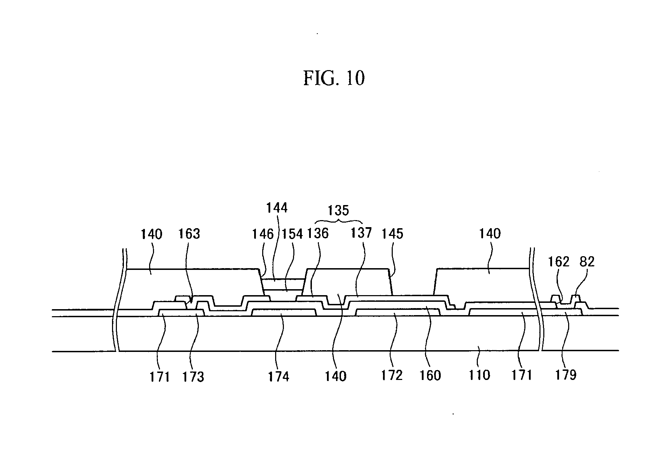

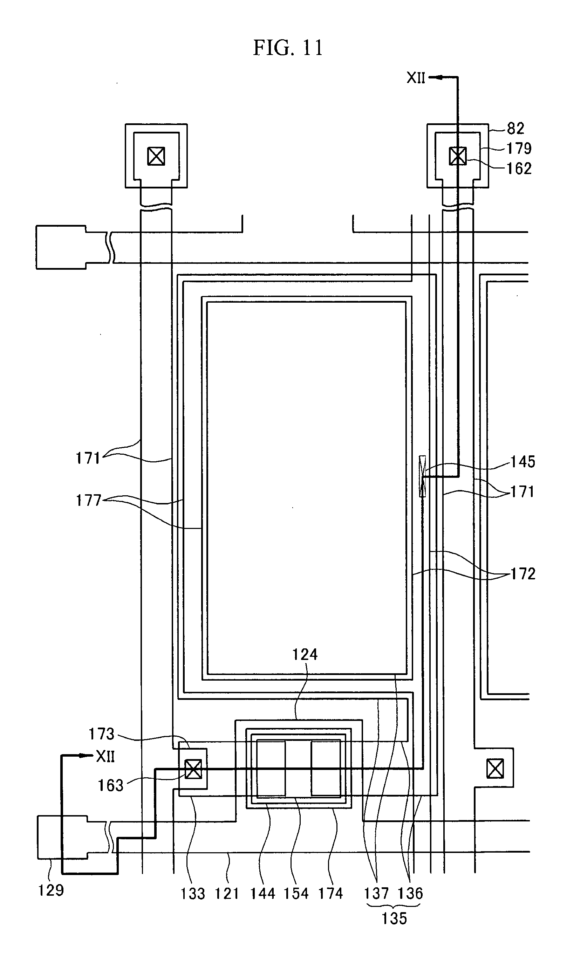

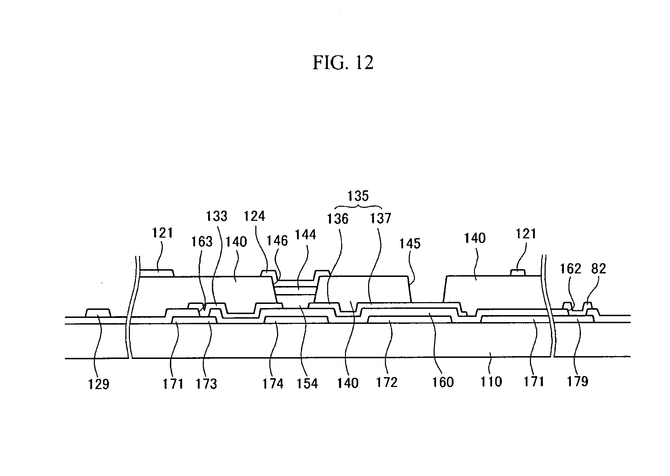

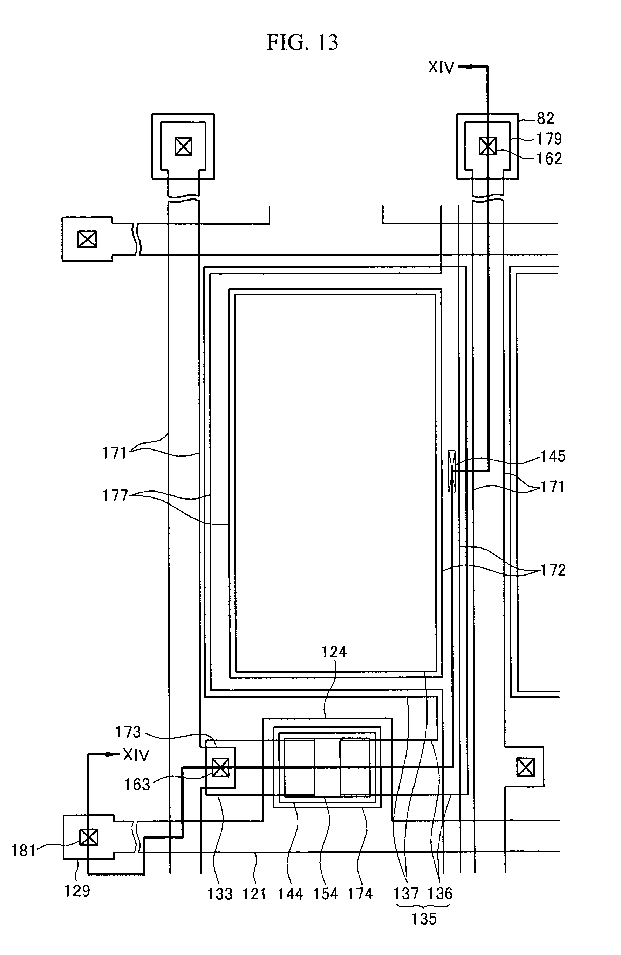

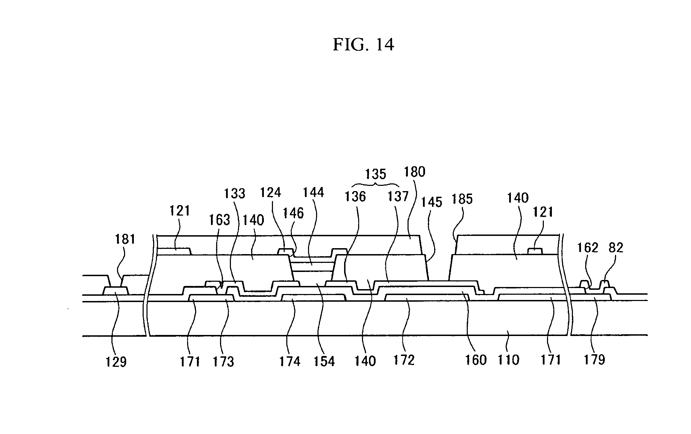

FIG. 3, FIG. 5, FIG. 7, FIG. 9, FIG. 11, and FIG. 13 are layout views sequentially showing a method of manufacturing the TFT array panel of FIG. 1 and FIG. 2 according to one embodiment of the present invention, FIG. 4 is a cross-sectional view taken along a line IV-IV of FIG. 3, FIG. 6 is a cross-sectional view taken along a line VI-VI of FIG. 5, FIG. 8 is a cross-sectional view taken along a line VIII-VIII of FIG. 7, FIG. 10 is a cross-sectional view taken along a line X-X of FIG. 9, FIG. 12 is a cross-sectional view taken along a line XII-XII of FIG. 11, and FIG. 14 is a cross-sectional view taken along a line XIV-XIV of FIG.13.

First, as shown in FIG. 3 and FIG. 4, a conductive layer is deposited on substrate 110 by, for example, a sputtering process, and the data lines 171 including the projections 173 and the end portions 179, the storage electrode lines 172 including the storage electrodes 177, and the light blocking layer 174 are formed by a photolithography process of the conductive layer.

Next, as shown in FIG. 5 and FIG. 6, the lower interlayer insulating layer 160, which is formed of SiNx, is deposited by chemical vapor deposition (CVD). Then a photosensitive layer is applied to the lower interlayer insulating layer 160, and contact holes 162 and 163 are formed by a photolithography process.

As shown in FIG. 7 and FIG. 8, the source electrodes 133, the drain electrodes 135, and the contact assistants 82 are formed by a photolithography process after sputtering ITO or IZO.

Next, as shown in FIG. 9 and FIG. 10, a photosensitive resin (not shown) is formed over the substrate. After the application and development of an acrylic photosensitive solution, the acrylic photosensitive resin is formed by thermally crosslinking the developed acrylic photosensitive solution at about 130°C to 250°C.

Subsequently, the upper interlayer insulating layer 140 having the plurality of openings 146 and the plurality of contact holes 145 is formed by patterning the photosensitive resin.

The acrylic photosensitive solution includes a fluorine-containing compound. The fluorine-containing compound may be, for example, fluoro-surfactant, fluoro-nanoparticles, or fluoropolymer nanobeads. Examples of these may be Zonyl™ (manufactured by Dupont Co.), Novec™ (manufactured by 3M Co.), Fluowet™ (manufactured by Clariant Co.), Lodyne™ (manufactured by Ciba Specialty Chemicals Co.), or Megaface™ (manufactured by DAINIPPON INK AND CHEMICALS Co.). The fluorine-containing compound is preferably contained in the amount of about 1 to 40 wt% based on the total content of the photosensitive organic material.

As described above, since the upper interlayer insulating layer 140 is made of the photosensitive solution including the fluorine-containing compound, the surface of the upper interlayer insulating layer 140 may have the hydrophobic properties.

Then, the organic semiconductors 154 are formed in the openings 146.

The organic semiconductors 154 are formed by injecting an organic semiconductor solution into the openings 146 through an ink jet printing process. The organic semiconductor solution includes the material having surface properties that are different from the upper interlayer insulating layer 140. Thus, the organic semiconductor solution does not flow over the upper interlayer insulating layer 140, but rather gathers only in the openings 146 at which the upper interlayer insulating layer is removed. Accordingly, it is possible to gather the organic semiconductor solution in the openings 146 without the surface-treating process using plasma.

Thereafter, the solvent of the organic semiconductor solution is allowed to evaporate.

Subsequently, the gate insulator 144 is formed in the opening 146. The gate insulator 144 is also formed by injecting an organic insulating solution onto the organic semiconductors 154 in the opening 146 through an ink-jet printing process. In this case, as described above, the solution is gathered on the organic semiconductors 154 in the openings 146. Thereafter, the solvent of the organic insulating solution is allowed to evaporate.

Next, as shown in FIG. 11 and FIG. 12, a conductive layer is applied by, for example, a sputtering process, and the gate lines 121 including the gate electrodes 124 and the end portions 129 are formed by the photolithography process of the conductive layer. As will be appreciated by reference to FIG. 12, the gate electrode 124 is formed such that it fully cover the opening 146.

Next, as shown in FIG.13 and FIG. 14, the passivation layer 180 is formed over the substrate, and the contact holes 181 and 185 are formed by a photolithography process.

Finally, as shown in FIG.1 and FIG. 2, the pixel electrodes 191 connected to the drain electrodes 135 through the contact holes 145 and 185 and the contact assistants 81 are formed.

As described above, since the embodiment of the invention defines hydrophobic and hydrophilic regions without the additional surface-treating process using plasma, it is possible to reduce the processes of the work and prevent the organic semiconductor or the like from flowing onto the interlayer insulating layer, thus correctly forming the organic semiconductor on only the desired portion.

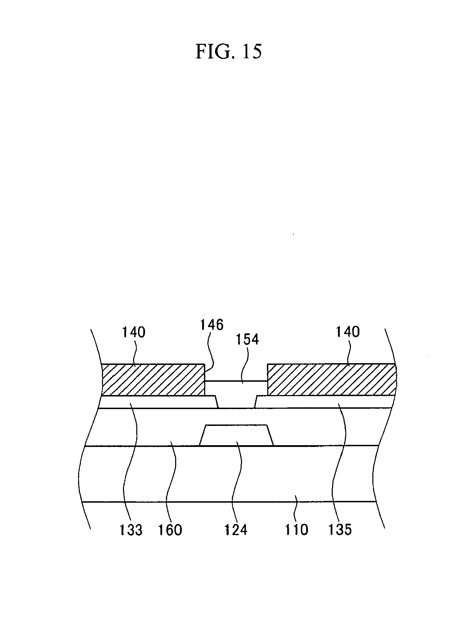

Now, a TFT array panel according to another embodiment of the present invention will be described with reference to FIG.15.

FIG. 15 is an enlarged cross-sectional view showing the TFT array panel according to another embodiment of the present invention.

Unlike the top gate structure of the above-described embodiment, the TFT array panel according to this embodiment has a bottom gate structure. Considering the only TFT portion, the gate electrodes 124 are formed on the substrate 110, and the lower interlayer insulating layer 160 is formed on the gate electrodes 124. The lower interlayer insulating layer 160 serves as a gate insulating layer. The source electrodes 133 and the drain electrodes 135 are formed on the lower interlayer insulating layer 160 so as to face each other about the gate electrodes 124, and the upper interlayer insulating layer 140 having the openings 146 that expose a portion of the source electrodes 133 and the drain electrodes 135 is formed on the source electrodes 133 and the drain electrodes 135. Moreover, the organic semiconductor 154 is filled in the openings 146.

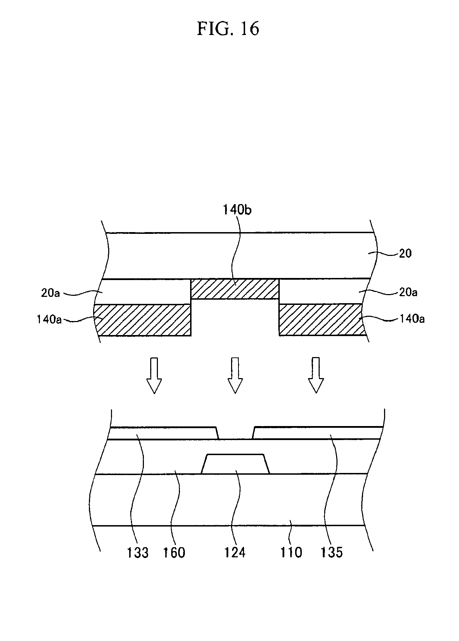

The method of manufacturing the TFT array panel of FIG. 15 is described below with reference to FIG.16 to FIG.18.

FIG. 16 to FIG. 18 are cross-sectional view showing sequentially the method of manufacturing the TFT array panel of FIG. 15 according to an embodiment of the present invention.

First, referring to FIG. 16, a conductive layer is applied to the substrate 110, and the gate electrodes 124 are formed by the photolithography process of the conductive layer. Interlayer insulating layer 160 is formed on the gate electrodes 124. Subsequently, a conductive layer is applied to the interlayer insulating layer 160, and the source electrodes 133 and the drain electrodes 135 are formed by a photolithography and etching process of the conductive layer.

Then, a printing plate 20 for performing a microcontact printing process is disposed above the substrate 110.

The printing plate 20 may be a mold or a stamp, and a plurality of convex portions 20a are formed at one side of the printing plate 20. Alternatively, a plurality of concave portions rather than the convex portions 20a may be formed at one side of the printing plate 20.

A photosensitive organic layer is applied on the printing plate 20. The photosensitive organic layer includes first portions 140a applied on the convex portion 20a and second portions 140b applied on the region other than the convex portion 20a. The first portions 140a are to be transferred onto the substrate. The photosensitive organic layer contains a resin having a thermal or light cross-linkage ability, and may have etching-resistance.

Then, the first portions 140a of the photosensitive organic layer are transferred onto the substrate by pressurizing the printing plate 20 on the substrate in the arrow direction.

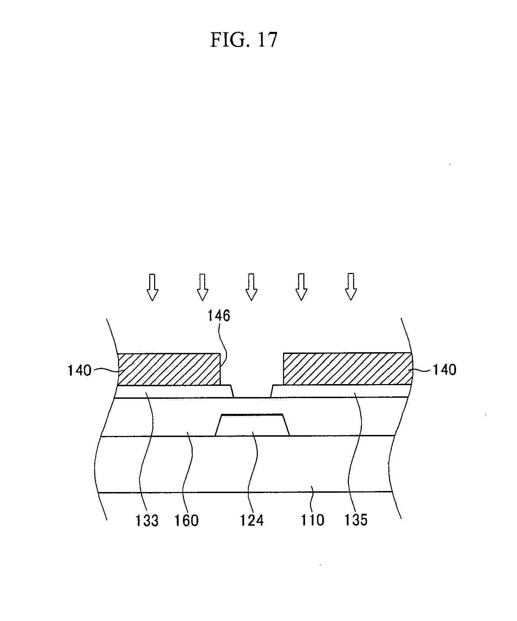

After evaporation of the solvent from the photosensitive organic layer, as shown in FIG. 17, the upper interlayer insulating layer 140 is formed. At this time, the thickness of the upper interlayer insulating layer 140 is about 10Å to about 7000Å, and is preferably about 1000Å. The openings 146 are formed at the regions other than the transferred first portions 140a.

Next, the surface of the upper interlayer insulating layer 140 may be modified to have the hydrophobic or hydrophilic properties by a surface-treating process using plasma.

In case of this embodiment of the invention, for example, the upper interlayer insulating layer 140 may be treated with fluorine under a plasma atmosphere. For example, fluorine-containing gases such as CF₄, C₂F₆, or SF₆ are supplied into a dry etching chamber together with O₂ and/or an inert gas. In this case, the upper interlayer insulating layer 140 made of the organic materials is treated with fluorine by carbon-fluorine (C-F) bonds at the surface thereof. However, since the source electrodes 133, the drain electrodes 135, and the lower interlayer insulating layer 160 that are exposed through the openings 146 are made of inorganic materials, these are not treated with fluorine.

By forming the insulating layer using the above-described microcontact printing process, it is possible to form the insulating layer thinly. In addition, since a photolithography process is not additionally required for the formation of the insulating layer, it is possible to simplify the manufacturing method and to reduce working time and cost.

Furthermore, as described above, by treating the surface of the upper interlayer insulating layer 140 with fluorine, the surface of the upper interlayer insulating layer 140 is modified to have the hydrophobic properties, and the portions exposed through the openings 146 may have relatively hydrophilic properties.

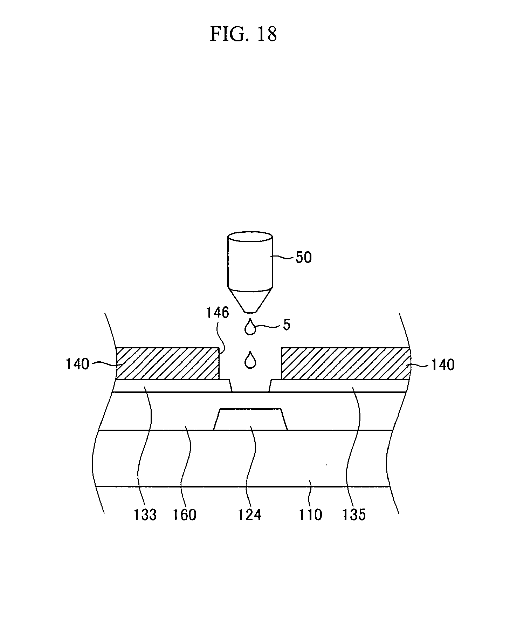

Next, referring to FIG. 18, an inkjet head 50 is disposed over the opening 146 to eject an ink solution. In this way, the organic semiconductor 154 as shown in FIG. 15 is formed.

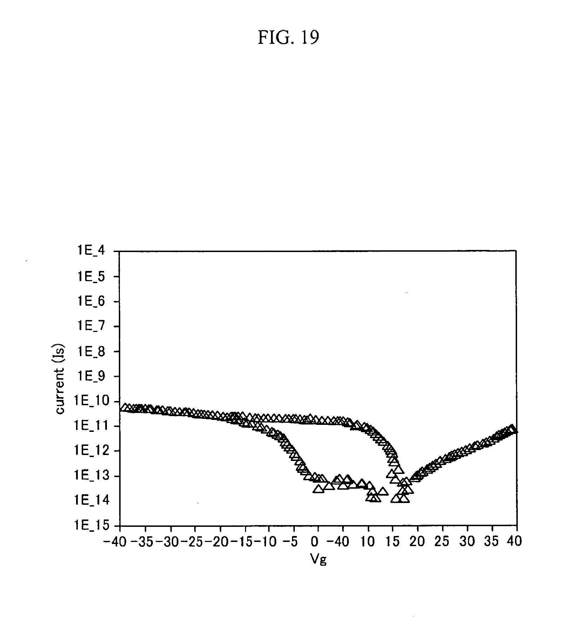

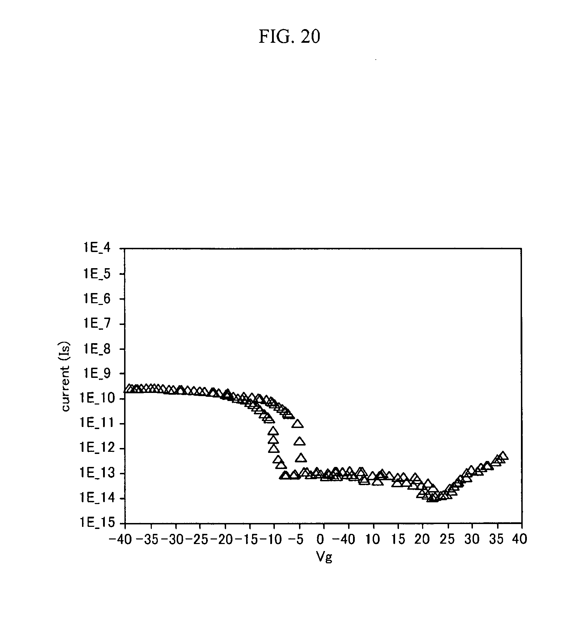

FIG. 19 and FIG. 20 are plots showing current characteristics of the TFT array panel according to one embodiment of the invention in the case of forming the upper interlayer insulating layer 140 with a thin thickness using the microcontact printing.

FIG. 19 is the graph showing the voltage-current curve of the TFT having the upper interlayer insulating layer 140 of a thickness of about 7500Å according to the prior art, while FIG. 20 is a plot showing the voltage-current curve of the TFT having the upper interlayer insulating layer 140 of a thickness of about 1000Å according to an embodiment of the invention. In FIG. 19 and FIG. 20, the x-axis indicates the value of a gate voltage Vg, and the y-axis indicates the value of a source current Is.

As shown in FIG. 19, it can be seen from the voltage-current curve of the TFT having the upper interlayer insulating layer 140 of a thickness of about 7500Å that the varying range of the gate voltage Vg between on-current (10⁻¹⁰⁻¹¹) and off-current (10⁻¹³⁻¹⁴) is wide. However, as shown in FIG. 20, it can be also seen from the voltage-current curve of the TFT having the upper interlayer insulating layer 140 of a thickness of about 1000Å, the varying range of the gate voltage Vg between on-current (10⁻⁹⁻¹⁰) and off-current (10⁻¹³⁻¹⁴) is narrow.

As described above, it can be understood from the current-voltage curve of the TFT having the upper interlayer insulating layer 140 of a thickness of about 7500Å that the on-off characteristics are poor to show a large amount of hysteresis. However, it can be understood from the current-voltage curve of the TFT having the upper interlayer insulating layer 140 of a thickness of about 1000Å that the on-off characteristics are good to show a small amount of hysteresis.

Accordingly, it is possible to obtain stable TFT characteristics by using the thin upper interlayer insulating layer 140.

The method of forming an upper interlayer insulating layer 140 through microcontact printing process can be easily applied to manufacturing the TFT array panel of Figs. 1 and 2, which has a top gate structure.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A thin film transistor array panel comprising:
a substrate;
a data line formed on the substrate;
a gate line formed on the substrate, the gate line including a gate electrode;
a source electrode connected to the data line;
a drain electrode facing the source electrode;
an insulating layer having an opening, and wherein the insulating layer is comprised of an acrylic photosensitive resin having a fluorine-containing compound; and
an organic semiconductor formed in the opening, the organic semiconductor contacting the source electrode and the drain electrode.

2. The thin film transistor array panel of claim 1, wherein the acrylic photosensitive resin is comprised of a cross-linkable material.

3. The thin film transistor array panel of claim 2, wherein the fluorine-containing compound includes at least one of a fluoro-surfactant, fluoro-nanoparticles, or fluoropolymer nanobeads.

4. The thin film transistor array panel of claim 3, wherein the fluorine-containing compound is contained at about 1 to 40 wt% within the insulating layer..

5. The thin film transistor array panel of claim 1, wherein the insulating layer has a thickness of from about 10 Å to 7000 Å.

6. The thin film transistor array panel of claim 5, wherein a top surface of the insulating layer has stronger hydrophobic property than a portion contacting a bottom surface of the organic semiconductor.

7. The thin film transistor array panel of claim 1, further comprising
a gate insulator located between the organic semiconductor and the gate electrode,
wherein at least one of the organic semiconductor and the gate insulator includes a soluble material.

8. The thin film transistor array panel of claim 1, wherein:
the data line and the source electrode include different materials, and
the source electrode and the drain electrode include indium tin oxide (ITO) or indium zinc oxide (IZO).

9. The thin film transistor array panel of claim 1, further comprising a light blocking layer located below the organic semiconductor.

10. A method of manufacturing a thin film transistor array panel, the method comprising:
forming a data line on a substrate;
forming a gate line on the substrate;
forming a source electrode connected to the data line and a drain electrode having a portion spaced apart from and facing the source electrode;
forming an insulating layer over the source electrode and the drain electrode, and forming an opening in the insulating layer which exposes a portion of drain electrode and the source electrode;
forming an organic semiconductor in the opening, wherein a portion of the organic semiconductor contacts the source electrode and the drain electrode;
wherein forming the insulating layer comprises forming an acrylic photosensitive resin layer having a fluorine-containing compound, and further wherein forming the opening comprises patterning the acrylic photosensitive resin layer.

11. The method of claim 10, wherein forming of the acrylic photosensitive resin layer comprises:
applying a photosensitive resin;
exposing and developing the photosensitive resin; and
thermally crosslinking the photosensitive resin at a temperature from about 130°C to 250°C.

12. The method of claim 10, wherein forming the organic semiconductor is performed by an ink jet printing process.

13. A method of manufacturing a thin film transistor array panel, the method comprising:
forming a data line on a substrate;
forming a first interlayer insulating layer on the data line;
forming a source electrode connected to the data line and drain electrode facing the source electrode on the first interlayer insulating layer;
forming an acrylic photosensitive resin layer having a fluorine-containing compound on the source electrode and the drain electrode;
forming a second interlayer insulating layer having an opening by patterning the photosensitive resin layer;
forming an organic semiconductor in the opening;
forming a gate insulator on the organic semiconductor; and
forming a gate line on the gate insulator and the second interlayer insulating layer.

14. The method of claim 13, wherein
forming the acrylic photosensitive resin layer comprises:
applying a photosensitive resin;
exposing and developing the photosensitive resin; and
thermally crosslinking the photosensitive resin at a temperature from about 130°C to 250°C.

15. The method of claim13, wherein forming the organic semiconductor and forming of the gate insulator are performed using an ink-jet printing process.

16. A method of manufacturing a thin film transistor array panel, the method comprising:
forming a gate line on a substrate;
forming a data line that intersects the gate line;
forming a source electrode connected to the data line and a drain electrode facing the source electrode;
forming an insulating layer having an opening; and forming in the opening an organic semiconductor contacting the source electrode and the drain electrode, wherein forming the insulating layer comprises:
applying a photosensitive organic layer to a surface of a printing plate having at least one of a concave portion and a convex portion,
transferring the photosensitive organic layer onto the substrate, and
drying the photosensitive organic layer.

17. The method of claim 16, further comprising subjecting a surface of the insulating layer to a treatment process.

18. The method of claim 17, wherein the treatment process comprises exposing the surface of the insulating layer to a fluorine-containing gas.

19. The method of claim 16, wherein the photosensitive organic layer comprises a fluorine-containing compound.

20. A method of manufacturing a thin film transistor array panel, the method comprising:
forming a data line on a substrate;
forming a gate linethat intersects the data line;
forming a source electrode connected to the data line and a drain electrode having a portion spaced apart from and facing the source electrode;
forming an insulating layer over the source electrode and the drain electrode, and forming an opening in the insulating layer which exposes a portion of drain electrode and the source electrode;
forming an organic semiconductor in the opening, wherein a portion of the organic semiconductor contacts the source electrode and the drain electrode;
wherein forming the insulating layer comprises applying a photosensitive organic layer to a surface of a printing plate having at least one of a concave portion and a convex portion,
transferring the photosensitive organic layer onto the substrate, and
drying the photosensitive organic layer.

21. The method of claim 20, further comprising subjecting a surface of the insulating layer to a treatment process.

22. The method of claim 21, wherein the performing the treatment process comprises exposing the surface of the insulating layer to a fluorine-containing gas.
